## Europäisches Patentamt
## European Patent Office ·
## Office européen des brevets

(11) Publication number: **0 097 479**
**B1**

(12) **EUROPEAN PATENT SPECIFICATION**

(45) Date of publication of patent specification: **27.05.87**

(51) Int. Cl.⁴: **G 01 L 27/00,** G 01 L 9/00, G 01 D 3/02, G 01 D 18/00

(21) Application number: **83303421.8**

(22) Date of filing: **14.06.83**

(54) Adjustable process variable transmitter.

(30) Priority: **17.06.82 US 389633**

(43) Date of publication of application:
**04.01.84 Bulletin 84/01**

(45) Publication of the grant of the patent:
**27.05.87 Bulletin 87/22**

(84) Designated Contracting States:
**DE FR GB**

(56) References cited:
**EP-A-0 035 403**
**GB-A-2 072 349**

**ADVANCES IN INSTRUMENTATION, vol. 36, part 2, October 1981, pages 667-680, ISA, Research Triangle Park, N.C., US; D.B. JUANARENA et al.: "A modular multichannel digital pressure transmitter for industrial applications"**

**HYDROCARBON PROCESSING, vol. 56, no. 7, July 1977, pages 179-180, Houston, US; G.F. RIEDMULLER: "To calibrate transmitters faster"**

(73) Proprietor: **HONEYWELL INC.**
**Honeywell Plaza**
**Minneapolis Minnesota 55408 (US)**

(72) Inventor: **Bayer, Stephen J.**
**741 Vance Drive**
**Fitzwatertown Pennsylvania 19038 (US)**
Inventor: **Olsen, Arthur M.**
**Newman Road, MR-1**
**Pennsburg Pennsylvania 18073 (US)**

(74) Representative: **Rentzsch, Heinz et al**
**Honeywell Europe S.A. Holding KG Patent- und Lizenzabteilung Postfach 184**
**D-6050 Offenbach am Main (DE)**

Courier Press, Leamington Spa, England.

## Description

The present invention is directed to process variable transmitters, and more specifically to a process variable transmitter having an adjustable operating range.

Process variable transmitters, such as pressure transmitters, are factory calibrated during their manufacture to produce a "zero" output of a preselected current value, e.g. 4 mA, at a zero fluid pressure input and a full scale output of a second preselected current value, e.g. 20 mA, at a fluid pressure input called the upper range limit or URL. It is often desired to change the range of the transmitter to satisfy the requirements of specific applications by the customer in which the transmitter is to be used. Such an adjustment enables the transmitter to measure an applied input, e.g., a fluid pressure input, that is within its lower range value (LRV) and upper range value (URV) and to produce an output between 4 and 20 mA which is proportional to the process variable input between the LRV and URV. The upper and lower range values are adjusted to change the range of the transmitter, so that the LRV occurs at some pressure above the zero fluid input pressure and the URV output occurs at some pressure below the upper range limit (URL).

In conventional devices, the range is changed by manually adjusting circuit potentiometers which set an amplifier gain and zero offset. Specifically, a pressure equal to the desired LRV is applied to the transmitter, and the zero adjust potentiometer is manipulated until the output of the transmitter is measured to be at the lower limit. A pressure equal to the desired URV is then applied to the transmitter, and the span (gain) adjust potentiometer is manipulated until the output is measured to be at the upper limit. In this adjustment procedure, the zero and span adjustments interact, i.e., changing one affects the other. For this reason, the aforesaid procedure must be repeated until the amount of adjustment required at either point is insignificant, i.e., does not significantly affect the calibration of the other point. Accordingly, it would be desirable to provide a process variable transmitter which has a variable operating range that is set by a single adjustment operation.

The main object of the present invention is to provide a process variable transmitter having an improved operating range adjustment.

Accordingly the present invention provides a process variable transmitter including a process variable sensor and adjustment means for setting the transmitter to produce a predetermined output signal range in response to desired lower and upper range values, characterized in that the adjustment means comprise a microcomputer, fed from the sensor via an analog-to-digital converter and feeding the output via a digital-to-analog converter, which performs a conversion process on the sensor output and is responsive to set lower limit and set upper limit control signals, applied to simultaneously with the upper and lower range values of the process variable, respectively, to adjust the parameters of the conversion process.

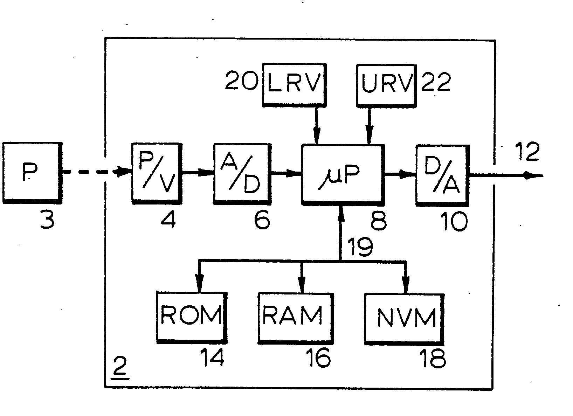

A pressure transmitter embodying the invention will now be described, by way of example, with reference to the drawing, which is a block diagram of the transmitter.

The drawing shows a process variable transmitter 2 which measures the fluid pressure from a pressure source 3. The output fluid pressure from the pressure source 3 is applied to a pressure sensor 4 feeding an analog-to-digital (A/D) converter 6, the digital output of which is fed to a microprocessor 8, which in turn feeds a digital-to-analog (D/A) converter 10, the output 12 of which is a current signal having a predetermined range, 4 mA to 20 mA, representing corresponding values of the fluid pressure from the source 3.

The microprocessor 8 is coupled via a bus 19 to a read only memory (ROM) 14, a random access memory (RAM) 16, and a nonvolatile read/write memory (NVM) 18, the microprocessor 8 and the three memories 14, 16, and 18 together forming a microcomputer. Two manually operable control signal sources, a Set-LRV source 20 and a Set-URV source 22, are coupled to the microprocessor 8.

The ROM 14 stores an equation which describes the input to output relationship of the transmitter:

$$\text{Output} = \text{DACO} + \left(\frac{\text{Input} - \text{LRV}}{\text{Span}}\right) \cdot \text{DACSPAN}. \tag{1}$$

In this equation,

DACO is the output of digital-to-analog converter 10 to produce 4 mA;

DACSPAN is the additional input to the converter which produces an additional output of 16 mA (giving a total output of 20 mA); and

$$\text{Span} = \text{URV} - \text{LRV}. \tag{2}$$

The values of LRV and Span are stored in the NVM 18. Initially, they are set at LRV=0, URV=URL and Span=URL. The range of the transmitter is changed by applying a pressure from the pressure source 3 equal to the desired LRV to the pressure sensor 4. Concurrently, a first digital control input signal from the Set-LRV source 20 is applied to the microprocessor 8, which thereupon replaces the old value of the pressure input (zero) by the current value, LRV, in the NVM 18, and automatically sets the output at 12 to 4 mA. Next, a pressure equal to the desired URV is applied to the pressure sensor 4 from the pressure source 3. At the same time, a second digital control input signal from the Set-URV source 22 is applied to the microprocessor 8, which thereupon replaces the old value of the input pressure (URL) by the current value, URV. A new Span is calculated by the microprocessor 8

using equation (2) to replace the old value in the NVM 18, and the output automatically is set to 20 mA by the microprocessor 8. The transmitter has thus now been re-ranged to operate between the new values of URV and LRV. The "Set-LRV" function affects only the LRV and URV, and the "Set-URV" function affects only the URV and Span. The result is a non-interacting zero and Span adjustment which eliminates the need to progressively fine tune the adjustments. It should be noted that the range of adjustment is not limited by the rangeability of an amplifier. For example, a reverse acting instrument may be produced simply by using an LRV pressure greater than the URV pressure.

### Claim

A process variable transmitter including a process variable sensor (4) and adjustment means for setting the transmitter to produce a predetermined output signal range in response to desired lower and upper range values, characterized in that the adjustment means comprise a microcomputer (8, 14—19), fed from the sensor via an analog-to-digital converter (6) and feeding the output (12) via a digital-to-analog converter (10), which performs a conversion process on the sensor output and is responsive to set lower limit and set upper limit control signals, applied to simultaneously with the lower and upper range values of the process variable, respectively, to adjust the parameters of the conversion process.

### Patentanspruch

Regelgrößenumformer mit einem Regelgrößensensor (4) sowie Einstellmitteln zum Einstellen des Umformers derart, daß er bei gewünschten unteren und oberen Bereichsgrenzwerten ein vorgegebenes Ausgangssignal liefert, dadurch gekennzeichnet, daß die Einstellmittel einen vom Sensor (4) über einen Analog/Digital-Umsetzer (6) gespeisten Mikrorechner (8, 14—19) aufweisen, der über einen Digital/Analog-Umsetzer (10) das Ausgangssignal (12) liefert und der bei Eingabe vorgegebener, der unteren und der oberen Bereichsgrenze entsprechender Steuersignale eine Umsetzung des Sensorausgangssignals durchführt, wobei ihm zum Anpassen der Parameter der Umsetzung gleichzeitig der unteren bzw. der oberen Bereichsgrenze der Regelgröße entsprechende Werte eingegeben werden.

### Revendication

Transducteur de variable de mesure comprenant un détecteur de variable de mesure (4) et un moyen de réglage pour régler le transducteur pour produire une gamme de signaux de sortie prédéterminée en réponse à des valeurs de gamme inférieure et supérieure désirées, caractérisé en ce que le moyen de réglage comprend un microordinateur, (8, 14—19) alimenté à partir du détecteur par l'intermédiaire d'un convertisseur analogique/numérique (6) et alimentant la sortie (12) par l'intermédiaire d'un convertisseur numérique/analogique (10) qui réalise un processus de conversion de la sortie du détecteur et agit en réponse à des signaux de commande de réglage de limite inférieure et de limite supérieure appliqués simultanément avec les valeurs de réglage inférieure et supérieure de la variable de mesure, respectivement, pour régler les paramètres du processus de conversion.